Europäisches Patentamt

European Patent Office

Office européen des brevets

(19)

(11) **EP 0 818 515 B1**

(12) **EUROPEAN PATENT SPECIFICATION**

(45) Date of publication and mention
of the grant of the patent:
**06.11.2002 Bulletin 2002/45**

(51) Int Cl.7: **C09D 4/06**, C09D 133/02,
C09D 133/06, C08L 33/02,
C08L 33/06, C08K 5/34,
C08K 5/45, C08K 5/00,
G03F 7/027

(21) Application number: **96907685.0**

(22) Date of filing: **28.03.1996**

(86) International application number:
**PCT/JP96/00819**

(87) International publication number:
**WO 96/030452 (03.10.1996 Gazette 1996/44)**

(54) **WATERBORNE PHOTOSENSITIVE RESIN COMPOSITION**

PHOTOEMPFINDLICHE HARZZUSAMMENSETZUNG AUF WASSERBASIS

COMPOSITION DE RESINE PHOTOSENSIBLE A BASE D'EAU

(84) Designated Contracting States:
**DE FR GB IT**

(30) Priority: **31.03.1995 JP 7586995**
**28.07.1995 JP 19353495**

(43) Date of publication of application:
**14.01.1998 Bulletin 1998/03**

(73) Proprietor: **MACDERMID INCORPORATED**
**Waterbury, Connecticut 06702 (US)**

(72) Inventors:
 • **SAMUKAWA, Hiroshi**
  **Kanagawa 243 (JP)**
 • **HAGIWARA, Yoshichi**
  **Kanagawa 243-02 (JP)**
 • **SAIGOU, Tsuyoshi**
  **Kanagawa 243 (JP)**

 • **HALLOCK, John, Scott**
  **Ellicott City, MD 21042 (US)**
 • **BECKNELL, Alan, Frederick**
  **Ellicott City, MD 21043 (US)**

(74) Representative:
**Held, Stephan, Dr.rer.nat., Dipl.-Chem. et al**
**Patentanwälte,**
**Hagemann, Braun und Held,**
**Postfach 86 03 29**
**81630 München (DE)**

(56) References cited:
**JP-A- 4 153 276      JP-A- 4 304 277**
**JP-A- 6 306 109      JP-B- 50 009 177**
**US-A- 5 387 494      US-A- 5 389 495**

 • **EDS. J. BRANDRUP E.H. IMMERGUT E.A.**
  **GRULKE: "Polymer Handbook Chap. VII p. 694",**
  **1999, JOHN WILEY & SONS, NEW YORK**

**Description**

TECHNICAL FIELD

This invention relates to a method for preparing a photosensitive resin composition containing no organic solvent. More particularly, this invention relates to a photosensitive resin composition in the form of a dispersion in water.

PRIOR ART

A solution or a dry film of a photosensitive resin has been widely used as a resist material for a chemical or electrochemical treatment of a substrate such as an etching or electroplating, etc. in the production or treatment of printed substrates. In recent years, due to environmental problems and health problems caused by organic solvents, a dilute alkali aqueous solution has been adopted for use as a developer solution in a development process after exposure to light in place of conventional organic solvents. However, the photosensitive resin itself often still contains an organic solvent, and volatilization of such organic solvents during coating or drying process still causes environmental problems. Consequently, studies have recently been started to make a photosensitive resin itself waterborne.

Japanese Patent Laid Open SHO 54-164119(1979) proposes a photosensitive resin composition composed of a water-dispersible latex and water-soluble or water-dispersible unsaturated compound. Further, a waterborne photosensitive resin composition composed of a water-dispersible latex and a water-insoluble unsaturated compound is described by Y. C. Chiou, et al. in MRL Bull. Res. Dev., Vol. 2, No. 2, p.13-17 (1988). However, it is reported in European Patent Application No. 0546767-A1 that the composition prepared by this method has a poor wettability against a copper substrate resulting in nonuniform coating or repellence, and it is therefore difficult to obtain uniformly coated film.

U.S. Patent No. 5,045,435 discloses a method for tackifying and stabilizing a water-dispersible latex by partially neutralizing it with a base, as an effective way to improve a coating property or stability of a waterborne photosensitive resin composition composed of a water-dispersible latex and a water-insoluble unsaturated compound. Thus, in this method, a part of the acid in the carboxylated (meth)acrylate latex is neutralized with amines or inorganic alkali, etc. to stabilize the composition and to regulate a rheology thereof when coated. Additionally, European Patent Application No. 0546768-A1 discloses a method for stabilizing a composition and regulating a rheology thereof when coated by adding a high molecular compound containing a carboxylic acid group which is water-solubilized by being highly neutralized with ammonia or amines. By this method, it is possible to obtain a composition which is stable and has appropriate rheological properties. However, when the present inventors evaluated resist properties of the waterborne photosensitive resin compositions prepared by the above disclosed methods, it was found that the compositions were apparently inferior to the organic solvent-type photosensitive resin compositions which are used commercially today, and none of them were satisfactory. Thus, when the waterborne photosensitive resin composition prepared by the conventional methods was coated on a copper substrate and dried to obtain a film, and the film was exposed to light and then developed with a dilute alkali aqueous solution, the uncured area was washed very slowly, a residue remained between the lines. This problem was particularly remarkable among lines having a space of 100 μm or less. Further, the cured area tended to swell or be damaged during a washing-out process or tended to peel off during a washing-out process. As a result, it was difficult to obtain a wide enough latitude in development.

Although a waterborne photosensitive resin composition having almost satisfactory rheological properties in its coating or a stability may have been provided by the known methods at present, resulting resist properties are obviously inferior to the existing solvent-type resist materials. Therefore, resist materials using a waterborne photosensitive resin composition are not yet commercially available at present.

DISCLOSURE OF INVENTION

It is the object of this invention to overcome the above-described problems of the conventional waterborne photosensitive resin composition and to provide a waterborne photosensitive resin composition having satisfactory resist properties which are equal to or better than the currently commercially available solvent-type photosensitive resin composition. Another object of this invention is to provide a waterborne photosensitive resin composition which is not sticky at room temperature when it is coated directly on a copper-clad laminate board and dried to form a coated film, which film may be contacted directly with the artwork (pattern).

The present inventors have extensively studied the development of a waterborne photosensitive resin composition having the above-described properties, and found that the waterborne resin composition comprising (a) an aqueous emulsion of a high molecular compound having a relatively low molecular weight and high acid value; (b) a photopolymerizable unsaturated compound; and (c) photopolymerization initiator; and (d) an adhesion promotor, as its indispensable constituents, exhibits extremely wide wash-out latitude. Based on this discovery, the present inventors finally accomplished this invention.

The following can be mentioned as the reasons why the composition of this invention shows extremely wide wash-out latitude. Namely, the use of an aqueous emulsion of a high molecular compound having a relatively low molecular weight and high acid value, which will be explained below as the component (a), greatly enhances the dissolution rate of the film obtained from the composition in a dilute alkali aqueous solution. As a result, the present composition solves the above-mentioned problems that the washing-out of the uncured area is slow and residues remain between the lines. In the cured area, since a part of the high molecular compound of the component (a) is washed out, the ratio of the photopolymer of the component (b) increases. Therefore, the coated film is changed to more hydrophobic, thus the cured area will not swell. However, when an aqueous emulsion of a high molecular compound having such a low molecular weight and high acid value is used, new problems may arise that the cured area will rapidly peel during washing-out process. In order to avoid this problems, it is very effective to add an adhesion promotor of the component (d). As a result, a waterborne photosensitive resin composition which shows an extremely wide wash-out latitude that washing-out speed is fast, residues between the lines may be well washed out and the cured area does not swell nor peel.

It has been known that adding a specific adhesion promotor to a photosensitive resin composition will result in improvement of the adhesion between the copper substrate and the photo-cured resist portion [See Japanese Patent Publication KOKOKU SHO 50-91177(1975)]. Such an adhesion promotor was conventionally added to a solvent-type photosensitive resin or particularly a dry film which has adhesion problems due to its laminated structure, to thereby prevent undercutting with an aqueous plating solution. According to the present invention, it has been discovered that addition of an adhesion promotor to a waterborne photosensitive resin composition composed of an aqueous emulsion having a specific molecular weight, acid value and glass transition temperature, extremely effectively prevents peeling of the cured area during development.

Thus, this invention relates to a waterborne photosensitive resin composition which may be developed with a dilute alkali aqueous solution, which comprises,

(a) an aqueous emulsion of a high molecular compound having a carboxyl group;
(b) a compound having a photopolymerizable ethylenic unsaturated bond;
(c) a photopolymerization initiator which can generate a free radical by irradiating with an active light; and
(d) an adhesion promotor;

as the indispensable constituents thereof,
characterized in that the high molecular compound of the component (a) has a weight-average molecular weight in the range from 1,000 to 20,000, an acid value of more than 140 mg-KOH/g and not more than 250 mg-KOH/g, and a glass transition temperature in the range of 50-200°C.

The component (a) in the composition of this invention can be prepared by copolymerizing a monomer having a carboxyl group (referred to as "component-A" hereinafter) and a monomer which is copolymerizable with it and has no carboxyl group (referred to as "component-B" hereinafter).

The component-A which is used to prepare the component (a) in the composition of this invention may include acrylic acid, methacrylic acid, maleic acid, itaconic acid, crotonic acid, cinnamic acid, etc.; and compounds prepared by adding an acid anhydride to acrylic acid esters or methacrylic acid esters which have a hydroxyl group. Acrylic acid and methacrylic acid are particularly preferred. Or, two or more such monomers may be used in combination.

Component-B includes acrylic acid esters and methacrylic acid esters having 1-10 carbon atoms in the ester portion, preferably methyl acrylate, ethyl acrylate, butyl acrylate, methyl methacrylate, ethyl methacrylate, butyl methacrylate, isobornyl methacrylate; those having a hydroxyl group such as hydroxyethyl acrylate, hydroxypropyl acrylate, hydroxyethyl methacrylate, hydroxypropyl methacrylate; those having a phenyl group such as phenoxyethyl acrylate, benzyl acrylate, and benzyl methacrylate. Known polymerizable monomers such as vinyl acetate, $\alpha$-methylstyrene, styrene, vinyltoluene, acrylamide, acrylonitrile, butadiene may also be used. While one monomer may be used as the component-B, it is more preferred to use a combination of two or more monomers to thereby adjust the hydrophilicity/ hydrophobicity balance and glass transition temperature of the obtained high molecular compound.

The weight-average molecular weight of the high molecular compound of the component (a) in the composition of this invention should be not more than 20,000. If the molecular weight exceeds this value, development speed may decrease during the development of the coated film formed from the composition, the residue may remain between the lines after washing-out process, the cured area may swell and be eliminated, or the edge may become unclear after drying. As a result, latitude of development may become narrower. These problems are also related to the glass transition temperature or acid value of the high molecular compound. If one wants to select the acid value or glass transition temperature freely within the specified range, the weight-average molecular weight of the high molecular compound must be lower. In this respect, more the weight-average molecular weight of the high molecular compound should not be more than 20,000.

While the acid value of the high molecular compound of the component (a) in the composition of this invention can be regulated by regulating the copolymerization ratio of the component-A to be used to prepare the high molecular compound, it is important that the acid value be more than 140 mg-KOH/g and not more than 250 mg-KOH/g. If the acid value of the high molecular compound is not more than 140 mg-KOH/g, it will be difficult to obtain the extremely wide wash-out latitude which is a characteristic of the photosensitive composition of this invention since it will be difficult to wash-out the high molecular compound of the component (a) from the cured area and it will therefore be impossible to convert the cured area to hydrophobic. On the other hand, if the acid value exceeds 250 mg-KOH/g, resist coating properties such as water resistance or resistance against etching solution of the formed coated film will be lost.

The glass transition temperature of the high molecular compound of the component (a) in the composition of this invention can be adjusted by selecting a proper combination of the component-B to be used for preparation of the high molecular compound. For example, if one wishes to lower the glass transition temperature of the high molecular compound, a monomer that will provide a lower glass transition temperature, such as ethyl acrylate or butyl acrylate, may be used as a part of the component-B. On the other hand, if one wishes to raise the glass transition temperature of the high molecular compound, a monomer that will provide a higher glass transition temperature, such as isobornyl methacrylate or acrylamide, etc., may be used as a part of the component-B. The glass transition temperature thus adjusted can be calculated using Fox's equation [Bulletin of American Physics Society, 1, 3, p.123 (1956)]. It is desirable that the thus-calculated glass transition temperature of the high molecular compound of the component (a) of this invention is within the range of 50-200°C. If the glass transition temperature of the high molecular compound is not more than 50°C, the composition will still sticky even after it is coated as a resist solution and dried on a substrate. Thus, it is difficult to contact the coated film with an artwork for exposure to light. On the other hand, if the glass transition temperature of the high molecular compound exceeds 200°C, it will be difficult to obtain uniform film after it is coated as a resist solution on a substrate and dried.

The aqueous emulsion of the high molecular compound of the component (a) in the composition of this invention can be prepared directly by polymerizing a selected monomer by an emulsion polymerization process or a suspension polymerization process. Alternatively, the high molecular compound may be first prepared in a solution form, and the solution is force-agitated in the presence of a surfactant to emulsify it, and subsequently remove the solvent. However, it is the most desirable from an economical view to directly prepare the aqueous emulsion of the high molecular compound by an emulsion polymerization process. Emulsion polymerization for preparing the component (a) of this invention can be conducted by any known method in the art. However, in order to obtain an aqueous emulsion of a high molecular compound having a weight-average molecular weight in the range of 1,000-20,000 which is necessary as the component (a) in the composition of this invention, it is preferred to use an inorganic or organic chain transfer agent in the polymerization reaction.

As the organic chain transfer agent, known chain transfer agents such as tert-dodecanethiol and 1-dodecanethiol can be used for this purpose. However, it is preferred to use a chain transfer agent that can lower the molecular weight more efficiently. For this purpose, it is advantageous to use a chain transfer agent that has a similar polarity as the high molecular compound of the component (a). In this respect, it is preferred to use thiols that have a solubility parameter (SP value) of 9 or higher, calculated by the method proposed by R. F. Fedors in Polymer Engineering Science, 14, p.147 (1974), as the chain transfer agent. Preferred examples of such a chain transfer agent are thioglycolic acid; thioglycolic acid derivatives such as methyl, ethyl, propyl, butyl, methoxybutyl or 2-ethylhexyl esters of thioglycolic acid, butanediol bisthioglycolate, ethyleneglycol bisthioglycolate; and 3-mercaptopropionic acid and its derivatives. The amount of the chain transfer agent to be added can be selected from the range of 0.1-10 weight % based on the total amount of the monomers.

Examples of the surfactant to be used in the emulsion polymerization are anionic surfactants such as alkyl sulfonate salts, alkylbenzene sulfonate salts, alkyldiphenylether disulfonate salts, naphthalenesulfonic acid/formalin condensation products, and polyoxyethylenealkylether sulfate; and a mixture of such an anionic surfactant with a nonionic surfactant such as a polyethyleneglycol ether, a polyoxyethylenesorbitan ester. Preferred is a combination of sodium dodecylbenzenesulfonate with a polyoxyethylenenonylphenyl ether, which is used generally in an emulsion polymerization. The amount of the surfactant to be used is preferably in the range of 1-8 weight % based on the total amount of the monomers, particularly 2-6 weight %. Although there is no particular restriction about the mixing ratio when an anionic surfactant and a nonionic surfactant are used together, it is preferred to use a nonionic surfactant in an amount equal to or less than the anionic surfactant since better stability of the acquired aqueous emulsion can be obtained.

The solid content in the aqueous emulsion which is used as the component (a) in this invention is preferably 25-60 weight %, particularly 35-50 weight %. If the content is less than 25 weight %, the concentration of the solids in the final composition will also low, and it will therefore require more time for drying and the viscosity will become lower, which causes disadvantages in coating. On the other hand, if the content of the solid exceeds 60 weight %, the coated film may dry too fast, the viscosity may rise too much, or the stability of the aqueous emulsion itself or its composition may become poor.

A monofunctional compound, bifunctional compound, polyfunctional compound, or a mixture thereof can be used as the compound having a photopolymerizable ethylenic unsaturated bond of the component (b) of this invention. However, since it is required to increase crosslinking density when the composition is cured, it is preferred to use bi- or polyfunctional compound as the main component and not to add a monofunctional compound in a large amount. A small amount of a monomer having a carboxyl group may be further added to the component (b) for the purpose of improving removability by a caustic soda in a process of removing the unnecessary resist after etching. The monomers which is convenient for this purpose may be the same as the component-A mentioned above to be used for preparation of the component (a), or a compound prepared by adding an acid anhydride to a hydroxyl group-containing acrylic acid esters or methacrylic acid esters may be used.

Examples of the preferred bifunctional compounds which can be used as the component (b) of this invention include ethyleneglycol diacrylate, diethyleneglycol diacrylate, triethyleneglycol diacrylate, polyethyleneglycol diacrylate, propyleneglycol diacrylate, dipropyleneglycol diacrylate, tripropyleneglycol diacrylate, polypropyleneglycol diacrylate, neopentylglycol diacrylate, ethylene oxide-modified neopentylglycol diacrylate, propylene oxide-modified neopentylglycol diacrylate, 1,6-hexanediol diacrylate, ethylene oxide-modified bisphenol-A diacrylate, propylene oxide-modified bisphenol-A diacrylate, glycerin diglycidylether diacrylate, and corresponding methacrylates.

Examples of the preferred polyfunctional compounds to be used as the component (b) of this invention include trimethylolpropane triacrylate, pentaerythritol triacrylate, pentaerythritol tetracrylate, dipentaerythritol pentacrylate, dipentaerythritol hexacrylate, and its ethylene oxide-modified or propylene oxide-modified acrylates, and the corresponding methacrylates.

Examples of the monofunctional compounds to be used as the component (b) of this invention include 2-hydroxyethyl acrylate, 2-hydroxypropyl acrylate, N-vinylpyrrolidone, acroylmorpholine, methoxytetraethyleneglycol acrylate, methoxypolyethyleneglycol acrylate, N,N-dimethyl acrylamide, N-methylol acrylamide, N,N-dimethylaminopropyl acrylamide, N,N-dimethylaminoethyl acrylate, N,N-dimethylaminopropyl acrylate, melamine acrylate, and the corresponding methacrylates; phenoxyethyl acrylate, tetrahydrofurfuryl acrylate, cyclohexyl acrylate, isobornyl acrylate and the corresponding methacrylates.

The high molecular compound of the component (a) in the composition of this invention should have good compatibility with the photopolymerizable ethylenic unsaturated compound of the component (b). If compatibility among these components is poor, the component (b) will not be incorporated in an aqueous emulsion particle of the component (a). As a result, the composition does not have long term stability. Further, when the composition is coated and dried on a copper substrate, clear and uniform coated film can not be obtained. Or, the ethylenic unsaturated compound which is the component (b) may bleed from the coated film. Such problems are easily visible when the film is examined under a microscope. If the component (a) does not have sufficient compatibility with the component (b), the compatibility of the component-A to the component-B can be adjusted by regulating the hydrophilicity/hydrophobicity balance of the high molecular compound using styrene, hydroxy acrylate, hydroxy methacrylate, phenoxy acrylate or 2-hydroxyphenoxypropyl acrylate as a part of the component-B to be used in the preparation of the high molecular compound of component (a).

Examples of the component (c) in the composition of this invention, which is a photopolymerization initiator that can generate a free radical by irradiation with an active light, include anthraquinones such as 2-ethyl-2-t-butylanthraquinone, 2-t-butylanthraquinone, octamethylanthraquinone, and 1,2-benzanthraquinone; $\alpha$-ketaldonyl alcohols or ethers such as benzoin, pivaloin or acyloin ether; ketones such as $\alpha$-phenylbenzoin, $\alpha$,$\alpha$'-diethoxyacetophenone, benzophenone, 4,4'-bisdialkylaminobenzophenone; thioxanthone derivatives; and 2,4,5-triarylimidazolyl dimers. These compounds may be used alone or as a mixture of two or more. The amount of the component (c) to be added is selected from the range of 1-50 weight% based on the total amount of the monomers.

Benzotriazole and its derivatives are used as adhesine promotors. The amount of the component (d) used in the present composition is in the range of 0.01-3 weight%, preferably 0.05-0.5 weight% based on the amount of solids in the composition.

It is preferred to add a known polymerization inhibitor in the amount of 50-2000 ppm with respect to the component (b) to the photosensitive resin composition of this invention, to thereby prevent polymerization reaction from occurring during its storage. Examples of the polymerization inhibitor include hydroquinone, hydroquinone monomethyl ether, pyrogallol, 2,6-di-tert-butyl-4-methylphenol and phenothiazine. Commercially available compounds that constitutes the component (b) of this invention often contains about 200-400 ppm of the such a polymerization inhibitor. In this case, an appropriate amount of the polymerization inhibitor may be added such that the total amount including the amount contained in the component (b) falls within the aforesaid range.

If necessary, known fillers such as barium sulfate, silicon oxide, talc, clay or calcium carbonate; known and conventional coloring agents such as leuko dyes, phthalocyanin green or carbon black; screening agent such as titanium oxide; leveling agent; antifoaming agent; viscosity modifier; or rheology modifier; may be added to the photosensitive resin composition of this invention.

PREPARATION METHOD

The waterborne photosensitive resin composition of this invention can be prepared by previously dissolving the component (c) and the component (d) in the component (b) at a temperature of not more than 60°C, and lowering the temperature to a room temperature to thereby prepare a monomer pre-mixture, and then uniformly dispersing the monomer pre-mixture in an aqueous emulsion of the component (a), to thereby absorb the monomer pre-mixture in particles of the aqueous emulsion. Thus, it is preferred to absorb the monomer pre-mixture in the particles of the aqueous emulsion in order to obtain a stable and uniform waterborne photosensitive resin composition. In order to make sure that the monomer pre-mixture has been completely absorbed in the particles of the aqueous emulsion, the simplest method is to check whether a uniform coated film has been obtained when the composition is coated on an appropriate substrate and then dried at about 80°C. If absorption is not sufficiently conducted, uniform coated film can not be obtained and oil droplets of the monomer will be observed under a microscope.

Specific methods for preparing the waterborne photosensitive resin composition of this invention are described below. Modification of the described methods, its combination or newly conceived methods may be used as long as the monomer pre-mixture can be absorbed in the similar manner in the particles of the aqueous emulsion.

(1) METHOD USING SURFACTANT

This method is to use a surfactant to thereby disperse the monomer pre-mixture uniformly in the aqueous emulsion of the component (a). As the component can be dispersed under a relatively mild agitating condition according to this method, it will not cause destruction of the particles of the aqueous emulsion. Further, since the dispersed particles are fairly small, it has an advantage that the monomer pre-mixture may be subsequently absorbed relatively quickly in the particles of the aqueous emulsion. In this method, the surfactant originally contained in the aqueous emulsion of the component (a) is not effective for dispersion, and an additional surfactant should be added. Amount of the additional surfactant may be in the range of 0.1-15% by weight based on the total amount of the monomers. The surfactant may be previously dissolved in the monomer pre-mixture, or may be previously dissolved in the aqueous emulsion of the component (a), or may be added together with the monomer pre-mixture to the aqueous emulsion.

(2) METHOD USING ULTRASONIC WAVE

This method is to directly mix the monomer pre-mixture with the aqueous emulsion of the component (a) using no surfactant, and then to irradiate this mixture with an ultrasonic energy to thereby disperse the monomer pre-mixture in the aqueous emulsion, and subsequently absorb them in the particles. In this method, it is preferred that at least more than 5 mg-KOH/g equivalent of the carboxyl groups in the aqueous emulsion of the component (a) is neutralized with a base. Neutralization of a part of the carboxyl group of the aqueous emulsion may stabilize the aqueous emulsion and reduce the tendency for the aqueous emulsion to aggregate by the impact of ultrasonic energy.

(3) METHOD USING NEUTRALIZED POLYMER

As explained below, this method is to previously highly neutralize a part of the aqueous emulsion of the component (a) to provide an aqueous solution, and then to uniformly disperse the monomer pre-mixture in the aqueous emulsion of the component (a) by a function of this aqueous solution similarly as a surfactant, and subsequently absorb the mixture in the aqueous emulsion.

Weight ratio of the high molecular compound which is the solid portion of the component (a) in the composition of this invention to the compound having an unsaturated bond of the component (b) is preferably from 9:1 to 5:5. If the ratio of the high molecular compound is higher than 9:1, sufficient crosslinking by the compound having an unsaturated bond cannot be provided, and thus excellent resolution can not be obtained. Also, in order to prepare an uniform coated film through fusion of the fine particles of the high molecular compound, it is preferred that the composition has a ratio of smaller than 9:1. If the ratio of the high molecular compound is smaller than 5:5, the obtained coated film will become sticky and it will no longer possible to contact the artwork directly with the coated film.

NEUTRALIZATION OF AQUEOUS EMULSION

It is preferred to neutralize a part of the carboxyl group in the aqueous emulsion of the high molecular compound having a carboxyl group of the component (a) in the composition of this invention, with an inorganic base or organic base. Examples of the preferred inorganic base that can be used for this purpose include alkali metal salts such as lithium hydroxide, sodium hydroxide and potassium hydroxide. Examples of the preferred organic base include ammonia and tertiary amines such as trimethylamine, triethylamine, dimethylethanolamine. Two or more bases may be mixed used in combination.

The first advantage of neutralizing a part of the carboxyl groups of the high molecular compounds is that it inhibits stickiness or blocking of the coated film after drying. The second advantage is that it stabilizes the aqueous emulsion by anionizing a part of the carboxyl group and stabilizes the composition. The third advantage is that it is possible to properly regulate the viscosity of the emulsion suitable for coating, because neutralization will raise the viscosity of the aqueous emulsion. Also, it can solve problems such as splashing. The fourth advantage is to allow addition of substances which are unstable under acidic condition in the composition of this invention because neutralization can bring the pH of the aqueous emulsion from acidic to near neutral.

While it is possible to practice this invention without neutralizing the high molecular compound of the aqueous emulsion, it is more preferred to neutralize the emulsion because neutralization has significant advantages as described above. The amount used for neutralization is such an amount that can neutralize 5-100 mg-KOH/g equivalent of the carboxyl group of the high molecular compound. If the amount of neutralization is less than 5 mg-KOH/g, the above-described advantages may not almost obtained. On the other hand, if the amount of neutralization exceeds 100 mg-KOH/g, the aqueous emulsion will become soluble in water, whereby it becomes impossible to absorb the component (b) in the particles of the aqueous emulsion, and miscibility of the emulsion with the component (b) becomes poor, and uniform coated film may therefore not be obtained.

[EFFECT OF INVENTION]

Because the photosensitive resin composition of this invention uses no organic solvent, it will never create problems caused by splash of an organic solvent, and this invention can provides a composition that has equal to or better latitude than the conventional solvent-type etching resist. Therefore, this invention can solve the problems of the conventional waterborne photosensitive resin composition and can provide a waterborne photosensitive resin composition which has equal to or better and satisfactory resist properties than the solvent-type photosensitive resin composition which is used commercially today. When the photosensitive resin composition of this invention is coated directly on a copper-clad laminate board and dried to form a coated film, it will not be sticky at room temperature and thus a coated film that can be contacted directly with the artwork can be obtained.

[EXAMPLES]

This invention is explained more specifically by way of the following examples which, however, are not intended to limit the scope of this invention.

PREPARATION 1: Preparation of Aqueous Emulsion 1 by Emulsion

Polymerization

An aqueous solution of a surfactant in deionized water in the amount ratio shown in Table 1 was added in a 500 ml separable flask equipped with an agitating device, a thermometer, a reflux condenser, and a dropping funnel, and then 1/8 portion of the monomer mixture was added to the flask. After the temperature of the flask was raised to 75°C, an APS solution of the polymerization initiator was added. Due to the heat of reaction, temperature of the reaction mixture raised to about 80°C. Then, the remaining 7/8 portion of the monomer mixture was added dropwise through the dropping funnel over a period of about 2 hours while maintaining the temperature. Thereafter, stirring was continued for additional 2 hours at the same temperature, and then the reaction mixture was allowed to cool to room temperature. The reaction mixture was filtered through a 100 mesh filter to obtain a milky white aqueous emulsion containing about 40 weight % of solid. This emulsion was called "aqueous emulsion 1".

Table 1

| Composition of Aqueous Emulsion 1 | |
|---|---|
| | Component (weight parts) |
| monomer mixture | |
| methyl methacrylate | 36 |
| ethyl acrylate | 34 |
| methacrylic acid | 30 |
| methyl thioglycolate (chain transfer agent) | 2 |

Table 1   (continued)

| Composition of Aqueous Emulsion 1 | |
| --- | --- |
| | Component (weight parts) |
| surfactant | |
| polyethyleneglycol nonylphenyl ether (EMULGEN 920, Kao K.K.) | 2 |
| sodium dodecylbenzene sulfonate | 2 |
| deionized water | 159 |
| polymerization initiator, APS (ammonium persulfate) | 0.4 |
| Total | 265.4 |

PREPARATION 2: Preparation of Aqueous Emulsion 2 or 3 by Emulsion Polymerization

The procedure of PREPARATION 1 was repeated, except that the amounts of the chain transfer agent was changed, ethyl acrylate was excluded from the monomer component, and/or styrene was added, to prepare aqueous emulsion 2 and 3 having higher glass transition temperature.

PREPARATION 3: Preparation of Aqueous Emulsion R1 and R2 by Emulsion Polymerization

In a similar manner as in PREPARATION 1, aqueous emulsions containing no chain transfer agent (R1) and containing a slight amount of chain transfer agent (R2) both of which contained 40 weight % of solid, were prepared. These were used as comparative examples that had higher molecular weight.

Weight-average molecular weights of the aqueous emulsions prepared in the above-described manner and an aqueous emulsion commercially available from Rohm and Haas Company (ACRYSOL I-2074) were measured by gel permeation chromatography (GPC) and results were calculated based on polyethylene oxide. These results are summarily presented in Table 2.

Table 2

| Properties of aqueous emulsions | | | | |
| --- | --- | --- | --- | --- |
| Aqueous emulsion No. | Composition ratio of monomers (weight %) | wt-av mol. weight | acid value | glass trans. temp. |
| | (wt%) | (Mw) | KOH-mg/g | Tg (°C) |
| 1 | MMA/EA/ MAA=36/34/30 | 7,800 | 160 | 100 |
| 2 | MMA/MAA=75/25 | 14,000 | 160 | 130 |
| 3 | MMA/St/ MAA=61/14/25 | 6,200 | 160 | 132 |
| R1 | MMA/MAA=77/23 | 316,000 | 150 | 128 |
| R2 | MMA/EA/MAA- 61/14/25 | 65,000 | 160 | 100 |
| ACRYSOL I-2074 | | 4,100 | 170 | 130 |
| MMA: methyl methacrylate; EA: ethyl acrylate MAA: methacrylic acid; St: styrene acid value: value calculated from the amount of methacrylic acid added. (For I-2074. measured value by alkalimetry) glass transition temperature: value calculated by Fox's equation: $$1/Tg = (w_1/Tg_1 + w_2/Tg_2 + w_3/Tg_3)$$ | | | | |

[$w_n$:weight fraction of each monomers; $Tg_n$:glass transition temperature of the homopolymer of each monomer]

[For I-2074. measured value by differential thermal analysis]

PREPARATION OF MONOMER PRE-MIXTURES 1 AND 2

Components shown in Table 3 were mixed in the weight ratio shown in the table, and heated at 50°C for about 30 minutes to dissolve completely, and then the solution was cooled to room temperature. A homogenous pale purple solution was obtained. They were called the monomer pre-mixture 1 containing benzotriazole (adhesion promotor) and the monomer pre-mixture 2 containing no benzotriazole. Each of these monomer pre-mixtures was used to prepare the waterborne photosensitive resin composition.

Table 3

| Mixing ratio of monomer pre-mixtures | | |
|---|---|---|
| Component | Pre-mix.1 (wt parts) | Pre-mix.2 (wt parts) |
| Leuco crystal violet (coloring agent) | 1.0 | 1.0 |
| Diethyl thioxanthone (photosensitizer, DETX, Nippon Kayaku K.K.) | 2.0 | 2.0 |
| IRUGACURE 907 (photoinitiator, Ciba-Geigy Co.) | 20.0 | 20.0 |
| IRUGACURE 651 (photoinitiator, Ciba-Geigy Co.) | 8.8 | 8.8 |
| Benzotriazole (adhesion promotor) | 0.5 | - |
| Dipentaerythritol pentacrylate (SARTOMER 399)[1] | 5.3 | 5.3 |
| Ethylene oxide-modified bisphenol-A diacrylate (SARTOMER 349)[1] | 20.6 | 20.6 |
| Ethylene oxide-modified trimethylolpropane triacrylate (SARTOMER 454)[1] | 42.3 | 42.3 |
| Total | 100.5 | 100.0 |

[1] Monomer manufactured by Sartomer Co.: It contains 250350 ppm of hydroquinone methyl ether (a polymerization inhibitor).

EXAMPLE 1

96 mg of lithium hydroxide monohydrate was dissolved in 1.5 g of deionized water to prepare an aqueous solution for neutralization. While 10 g of the aqueous emulsion 1 obtained in PREPARATION 1 was stirred with a magnetic stirrer, the aqueous lithium hydroxide solution was added dropwise into the aqueous emulsion. The viscosity of the solution was slightly increased, and a neutralized aqueous emulsion in which a part of the carboxyl groups corresponding to 32 mg-KOH/g (20 equivalent%) was neutralized, was obtained. Subsequently, 2.51 g of the above-mentioned monomer pre-mixture 1 was added to this neutralized aqueous emulsion. After stirring for several minutes, it was treated with ultrasonic energy for 30 minutes using a commercial ultrasonic cleaner. A homogeneous, stable waterborne photosensitive resin composition was thus obtained. This composition was coated on a substrate and dried at 80°C to obtain a clear glossy coated film. Even after the composition was left to stand for 1 week, there was observed no separation of the monomers. Composition ratio is shown in Table 4.

Table 4

| Mixing ratio of waterborne photosensitive resin composition | | |
|---|---|---|
| Major component | Weight (g) | Solid content (g) |
| Aqueous emulsion 1 | 10.00 | 4.00 |

Table 4   (continued)

| Mixing ratio of waterborne photosensitive resin composition | | |
|---|---|---|
| Major component | Weight (g) | Solid content (g) |
| Lithium oxide monohydrate solution | 1.596 | 0.096[1] |
| Monomer pre-mixture | 2.51 | 2.51 |
| Total | 14.106 | 6.606 |
| * Solid content of waterborne photosensitive resin composition = 6.606/14.106 x 100 = 46.8 (weight %) | | |

[1] Of those having an acid value of 160 mg-KOH/g, a portion corresponding to an acid value of 32 mg-KOH was neutralized (20 equivalent % was neutralized).

The thus-obtained waterborne photosensitive resin composition was coated on a clean copper-clad laminate board (the surface was chemically cleaned previously) using a No. 26 wire rod. This was dried in an oven at 80°C for 5 minutes. A clear and glossy coated film having uniform thickness of about 20 μm was obtained. The surface of this coated film was free of stickiness and completely dry. Then, a resolution chart having a line image upto 30 μm and a step tablet with stepwise different transmissibilities (Kodak Step Tablet No. 2, density step=0.15, density range= 0.05-3.05) was contacted directly with this substrate, and they were irradiated with UV light (160 mJ/cm$^2$), using a commercial UV exposure machine, under a reduced pressure. The substrate was immersed in a 1% aqueous solution of sodium carbonate regulated at 25°C, and developed while the aqueous solution being stirred. The minimum developing time required to wash off the unexposed area (referred to as "break point", hereinafter) and the developing time when the area cured through the step tablet starts to peel or swell, were measured. The ratio of these two developing times was calculated to obtain a latitude.

Thus,

$$\text{Latitude} = \text{(developing time when the area cured through 1-}$$

$$\text{6 steps of the step tablet starts to peel or swell)} /$$

$$\text{(break point)};$$

Break point was short (22 seconds), and upto the 9th step of the step tablet was cured. The latitude was 15-fold or more, which was extremely wide. The space between lines in the line image where five 30 μm wide lines were disposed at 30 μm interval, was washed off fairly well, and 30 μm line-and-space was developed excellently.

EXAMPLES 2 and 3

Using the aqueous emulsions 2 and 3 and in a similar manner as the method of Example 1, an uniform and stable waterborne photosensitive resin composition was prepared. The break point and latitude thereof were evaluated. The break point was sufficiently fast, and the latitude was more than 15-folds at maximum which was extremely wide.

EXAMPLE 4

An aqueous emulsion ACRYSOL I-2074 commercially available from Rohm and Haas Company (solid content was 46%) was diluted with deionized water to the solid content of 40%. In a similar manner as in Example 1, a waterborne photosensitive resin composition was prepared, and the break point and latitude were evaluated. The break point was fast (21 seconds) and the latitude was more than 15-folds. which was extremely excellent.

Results of the above-described examples are summarized in Table 5.

Table 5

| Developing property of waterborne photosensitive composition prepared from low molecular aqueous emulsions | | | | |
|---|---|---|---|---|
| Ex. | Aqueous emulsion | Wt.av. mol.wt. (GPC) | Breakpoint (sec) | Latitude[1] |
| 1 | 1 | 7,800 | 22 | >15 |
| 2 | 2 | 14,000 | 28 | >10 |
| 3 | 3 | 6,200 | 21 | >15 |
| 4 | ACRYSOL I-2074 | 4,100 | 21 | >15 |

[1] Latitude=(Time required by one of the cured areas cured through steps 1-6 of the step tablet to start peeling or swelling)/(break point)

COMPARATIVE EXAMPLE 1

A waterborne photosensitive resin composition was prepared in a similar manner as in Example 1 except that aqueous emulsion R1 having weight-average molecular weight of the high molecular compound of 316,000 obtained from PREPARATION 3, and the break point and latitude were evaluated. Break point was long and not suitable for practical use. Latitude was less than 1, and the cured area started to swell and expand before reaching the break point.

COMPARATIVE EXAMPLE 2

A waterborne photosensitive resin composition was prepared in a similar manner as in Example 1 except that aqueous emulsion R2 having weight-average molecular weight of the high molecular compound of 65,000 obtained from PREPARATION 3, and the break point and latitude were evaluated. Although break point was within the range suitable for practical use, latitude was narrow (1.1), and the cured area started to swell and expand immediately after reaching the break point.
It was found that a wide latitude could not be obtained when the molecular weight was high.
Results of the above-described Comparative Examples are summarized in Table 6.

Table 6

| Developing property of the waterborne photosensitive compositions prepared from aqueous emulsions having high molecular weight | | | | | |
|---|---|---|---|---|---|
| com. | Aqueous emulsion | Wt.av. mol.wt. (GPC) | Neutralization % | Breakpoint (sec) | Latitude |
| 1 | R1 | 316,000 | 19 | 380 | 0.5 |
| 2 | R2 | 65,000 | 20 | 87 | 1.2 |

COMPARATIVE EXAMPLE 3

A waterborne photosensitive resin composition was prepared in a similar manner as in Example 1 except that aqueous emulsion 3 obtained from PREPARATION 2 and monomer pre-mixture containing no benzotriazole were used, and the break point and latitude were evaluated. Although break point was fast as in Example 3, the cured area started to peel immediately after reaching the break point. Therefore, the latitude was narrow (1.5-folds).

COMPARATIVE EXAMPLE 4

In the similar manner as in Comparative example 3 and using an aqueous emulsion from Rohm and Haas Company (ACRYSOL I-2074), a waterborne photosensitive resin composition was prepared, and the break point and latitude were evaluated. Although break point was fast as in Example 4, the cured area started to peel after reaching the break point. Therefore, the latitude was narrow (2.0-folds). It was found that the cured area peeled off significantly in the absence of benzotriazole.
Results of the above-described comparative examples are summarized in Table 7.

Table 7

| Developing property of the waterborne photosensitive compositions prepared from aqueous emulsions having low molecular weight and containing no benzotriazole | | | | |
|---|---|---|---|---|
| Comp. Ex. | Aqueous emulsion | Wt.av. mol.wt. (GPC) | Breakpoint (sec) | Latitude |
| 3 | 3 | 6,200 | 21 | 1.5 |
| 4 | ACRYSOL I-2074 | 4,100 | 21 | 2.0 |

REFERENCE 1

4 g of Styrene/maleic acid copolymer (SCRIPSET 550, a product of Monsanto Company) and 2.51 g of the monomer pre-mixture 1 were dissolved in 8 g of propylene glycol methylether acetate to obtain a solvent-type photosensitive resin composition. This composition was evaluated for break point and latitude by the method described in Example 1. both of the break point and latitude were nearly identical to the solvent-type photosensitive resin compositions currently available on the market. Thus, it was demonstrated that solvent-type is practical, even when the molecular weight was high.

REFERENCE 2

Using the monomer pre-mixture 2, a solvent-type photosensitive resin composition containing no benzotriazole was prepared in the same procedure of Reference 1. Break point and latitude were nearly identical to those of Reference 1. Thus, it was found that, in the solvent-type photosensitive resin composition prepared by the prior art, addition of benzotriazole did not improve its latitude.

Results of the above References are summarized in Table 8.

Table 8

| Effect of addition of benzotriazole to the solvent type photosensitive resin compositions | | | | |
|---|---|---|---|---|
| Ref. Exam. | Resin[1] | Benzotriazole (wt %/resin) | Breakpoint (sec) | Latitude |
| 1 | SCRIPSET 550 | 0.3% | 62 | 4 |
| 2 | SCRIPSET 550 | NONE | 62 | 4 |

[1] Result of measurement by GPC showed that the weight-average molecular weight of SCRIPSET 550 was 72,200.

EXAMPLE 5

A waterborne photosensitive resin composition was prepared in the similar manner as in Example 2, except using the aqueous emulsion 3 and a monomer pre-mixture that contained same amount of a benzotriazole derivative (BT-LX, a product of Jouhoku Kagaku Kogyo K.K.) instead of the benzotriazole, and its break point and latitude were evaluated. The break point was sufficiently fast, and the latitude was sufficiently wide. It was found that same effect could be obtained by using a benzotriazole derivative.

Result of Example 5 is presented in Table 9.

Table 9

| Developing property of the waterborne photosensitive composition containing different adhesion promoters | | | | |
|---|---|---|---|---|
| Ex. | Adhesion promotor | Aqueous emulsion | Breakpoint (sec) | Latitude |
| 5 | BT-LX[*] | 3 | 24 | >12 |

[*] Product of Jouhoku Kagaku Kogyo K.K.:
1-[N,N-bis(2-ethylhexyl)aminomethyl]benzotriazole

**Claims**

1. A waterborne photosensitive resin composition which may be developed with a dilute alkali aqueous solution, which comprises

(a) an aqueous emulsion of a high molecular compound having a carboxyl group;

(b) a compound having a photopolymerizable ethylenic unsaturated bond;

(c) a photopolymerization initiator which can generate a free radical by irradiating with an active light; and

(d) an adhesion promotor selected from benzotriazole or derivatives thereof; as the indispensable constituents thereof,

**characterized in that** the aqueous emulsion of the component (a) is prepared by emulsion polymerization in the presence of a chain transfer agent, the high molecular compound of the component (a) has the weight-average molecular weight in the range from 1,000 to 20,000, an acid value of more than 140 mg-KOH/g and not more than 250 mg-KOH/g, and a glass transition temperature in the range of 50-2000C.

2. The waterbome photosensitive resin composition which may be developed with a dilute alkali aqueous solution according to Claim 1, wherein a portion of the carboxylic acid corresponding to 5-100 mg-KOH/g in the aqueous emulsion of component (a) is pre-neutralized with a base.

3. The waterborne photosensitive resin composition which may be developed with a dilute alkali aqueous solution according to Claim 1 or 2, wherein the aqueous emulsion of the component (a) is prepared by an emulsion polymerization using thioglycolic acid, 3-mercaptopropionic acid or esters thereof as the chain transfer agent.

4. The waterbome photosensitive resin composition which may be developed with a dilute alkali aqueous solution according to Claim 1, wherein the acid component of the high molecular compound in the aqueous emulsion of the component (a) is acrylic acid or methacrylic acid, and the other comonomer component is selected from methacrylic acid esters, acrylic acid esters, styrene, and vinyl esters.

5. A printed circuit board manufactured by using the waterborne photosensitive resin composition which may be developed with a dilute alkali aqueous solution according to any one of Claims 1 through 4.

**Patentansprüche**

1. Photoempfindliche Harzzusammensetzung auf Wasserbasis. die mit einer verdünnten, wäßrigen Alkalilösung entwickelt werden kann, die

(a) eine wäßrige Emulsion einer hochmolekularen Verbindung, die eine Carboxyl-Gruppe hat;

(b) eine Verbindung, die eine photopolymerisierbare ungesättigte Bindung hat;

(c) einen Photopolymerisationsinitiator, der durch Bestrahlung mit einem aktiven Licht ein freies Radikal bilden kann; und

(d) einen Haftbeschleuniger, der aus Benzotriazol oder Derivaten davon ausgewählt ist;

als unbedingt erforderliche Bestandteile umfaßt, **dadurch gekennzeichnet, daß** die wäßrige Emulsion der Komponente (a) durch Emulsionspolymerisation in Gegenwart eines Kettenübertragungsmittels hergestellt wird, die hochmolekulare Verbindung der Komponente (a) ein Gewichtsmittel des Molekulargewichts im Bereich von 1000 bis 20 000, eine Säurezahl von mehr als 140 mg KOH/g und nicht mehr als 250 mg KOH/g und eine Glasübergangstemperatur im Bereich von 50 bis 200°C hat.

2. Photoempfindliche Harzzusammensetzung auf Wasserbasis, die mit einer verdünnten, wäßrigen Alkalilösung entwickelt werden kann, nach Anspruch 1, **dadurch gekennzeichnet, daß** ein Teil der Carbonsäure, der 5 bis 100 mg KOH/g entspricht, in der wäßrigen Emulsion von Komponente (a) mit einer Base vorneutralisiert ist.

3. Photoempfindliche Harzzusammensetzung auf Wasserbasis, die mit einer verdünnten, wäßrigen Alkalilösung entwickelt werden kann, nach Anspruch 1 oder Anspruch 2, **dadurch gekennzeichnet, daß** die wäßrige Emulsion der Komponente (a) durch Emulsionspolymerisation unter Verwendung von Thioglycolsäure, 3-Mercaptopropionsäure oder Estern derselben als Kettenübertragungsmittel hergestellt wird.

4. Photoempfindliche Harzzusammensetzung auf Wasserbasis, die mit einer verdünnten, wäßrigen Alkalilösung entwickelt werden kann, nach Anspruch 1, **dadurch gekennzeichnet, daß** die hochmolekulare Verbindung in der wäßrigen Emulsion der Komponente (a) Acrylsäure oder Methacrylsäure ist und die andere Comonomer-Komponente aus Methacrylsäureester, Acrylsäureestern, Styrol und Vinylestern ausgewählt ist.

5. Gedruckte Leiterplatte, die unter Verwendung der photoempfindlichen Harzzusammensetzung, die mit einer verdünnten, wäßrigen Alkalilösung entwickelt werden kann, nach einem der Ansprüche 1 bis 4 hergestellt wurde.

**Revendications**

1. Composition de résine photosensible aqueuse qui peut être développée avec une solution aqueuse alcaline diluée, qui comprend

   (a) une émulsion aqueuse d'un composé de haut poids moléculaire ayant un groupe carboxyle;
   (c) un composé ayant une liaison insaturée éthylénique photopolymérisable ;
   (c) un initiateur de photopolymérisation qui peut engendrer un radical libre par irradiation avec une lumière active ; et
   (d) un activateur d'adhérence choisi entre le benzotriazole et ses dérivés ; comme constituants indispensables de cette composition,

   **caractérisée en ce que** l'émulsion aqueuse du constituant (a) est préparée par polymérisation en émulsion en présence d'un agent de transfert de chaîne, le composé de haut poids moléculaire du constituant (a) a une moyenne en poids du poids moléculaire comprise dans l'intervalle de 1000 à 20 000, un indice d'acide supérieur à 140 mg de KOH/g et non supérieur à 250 mg de KOH/g, et une température de transition vitreuse comprise dans l'intervalle de 50 à 200°C.

2. Composition de résine photosensible aqueuse qui peut être développée avec une solution aqueuse alcaline diluée suivant la revendication 1, dans laquelle une partie de l'acide carboxylique correspondant à une valeur de 5 à 100 mg de KOH/g dans l'émulsion aqueuse du constituant (a) est préneutralisée avec une base.

3. Composition de résine photosensible aqueuse qui peut être développée avec une solution aqueuse alcaline diluée suivant la revendication 1 ou 2, dans laquelle l'émulsion aqueuse du constituant (a) est préparée par une polymérisation en émulsion en utilisant de l'acide thioglycolique, de l'acide 3-mercaptopropionique ou leurs esters, comme agent de transfert de chaîne.

4. Composition de résine photosensible aqueuse qui peut être développée avec une solution aqueuse alcaline diluée suivant la revendication 1, dans laquelle le constituant acide du composé de haut poids moléculaire dans l'émulsion aqueuse du constituant (a) est l'acide acrylique ou l'acide méthacrylique, et l'autre constituant comonomère est choisi entre des esters d'acide méthacrylique, des esters d'acide acrylique, le styrène et des esters vinyliques.

5. Carte de circuits imprimés produite en utilisant la composition de résine photosensible aqueuse qui peut être développée avec une solution aqueuse alcaline diluée suivant l'une quelconque des revendications 1 à 4.